# EUROPEAN PATENT SPECIFICATION

(11) **EP 1 442 647 B1**
(45) Date of publication and mention of the grant of the patent: **22.12.2010**
(21) Application number: 02802773.8
(22) Date of filing: 27.09.2002
(51) Int. Cl.: H05K 13/04, H05K 13/08

(54) **SYSTEM AND METHOD FOR RAPID ALIGNMENT AND ACCURATE PLACEMENT OF ELECTRONIC COMPONENTS ON A PRINTED CIRCUIT BOARD**
VERFAHREN UND VORRICHTUNG FÜR SCHNELLE POSITIONIERUNG UND GENAUE PLAZIERUNG VON ELETRONISCHEN BAUTEILEN AUF EINER LEITERPLATTE
SYSTEME ET PROCEDE D'ALIGNEMENT RAPIDE ET DE PLACEMENT PRECIS DE COMPOSANTS ELECTRONIQUES SUR UNE CARTE DE CIRCUIT IMPRIME

(30) Priority: 02.11.2001 US 53512
(43) Date of publication of application: 04.08.2004
(73) Proprietor: Delaware Capital Formation, Inc., Wilmington, Delaware 19803-2755 (US)
(72) Inventor: CARLOMAGNO, Mike, Chico, CA 95973 (US); MISHIN, Artem, San Francisco, CA 94131 (US); COWELL, Mark, San Carlos, CA 94070 (US)
(74) Representative: Diehl, Hermann O. Th.
(86) International application number: PCT/US2002/030757
(87) International publication number: WO 2003/041480

(56) References cited:
- US-A- 5 044 072
- US-A- 5 195 234
- US-A- 5 903 662

## Description

### Technical Field

The present invention relates in general to optical positioning systems and in particular to heated gas soldering / desoldering systems for placing or removing integrated circuit chips from printed circuit boards.

### Background of the Invention

The fabrication of modem electronic components typically involves the attachment of electronic components such as integrated circuits onto printed circuit boards. Such integrated circuits are first positioned at the desired location on the circuit board and are then soldered by heated gasses into position. Such positioning and soldering operations require precise control for at least the following reasons.

Integrated circuit chips typically comprise an array of small balls or solder columns which extend downwardly from the back of the chip and/or small leads which extend downwardly from the perimeter of the chip. Each of these balls, columns or leads must be accurately positioned so as to be received within a contact area on the printed circuit board. As the development of more and more advanced integrated circuits continues, successive integrated circuits have larger and larger numbers of balls/ leads extending therefrom. Consequently, the separation distance between successive balls/ leads in the arrays have become smaller and smaller.

As can be appreciated, as progressively smaller and more complex arrays are developed, it becomes more and more difficult to accurately position the integrated circuit chips on the printed circuit boards. For example, today's integrated circuit chips may have ball arrays as small as 1 mm². Such ball arrays may have a "pitch" (i.e.: the distance between adjacent solder balls) as small as 0.3 mm. Thus, due to the small size of the individual balls in an array, accurately positioning the integrated circuit chip at the exact desired position on the printed circuit board requires a system which is capable of very accurate controlled fine movement.

Furthermore, precise control is also required when soldering the integrated circuit chips into position. Specifically, it is desirable to achieve a uniform temperature across the chip's ball array, thereby soldering all of the balls of the array into their respective contact areas on the circuit board. However, it is also important that such heating of the desired component on the printed circuit board does not result in excessive heating of adjacent electrical components on the circuit board. Specifically, excess heating of adjacent components may cause the solder of the adjacent components to reflow, potentially resulting in the disconnection of some of their balls or leads.

Accordingly, what is desired is a system which uniformly raises the temperature of a large area of the circuit board to a temperature which is just under the solder melt temperature. Localized heating is then applied to raise the temperature of the balls or leads under the electronic component being positioned to a temperature which is just under the solder melt temperature. This approach minimizes temperature gradients under the chip, while keeping the temperature of adjacent components below a solder melt / reflow temperature.

There are two basic types of existing positioning systems. In the first type of system, the printed circuit board is held at a fixed location and a tool head (comprising a heated gas soldering head) is automatically positioned at a preferred location above the printed circuit board. The integrated circuit chip (or other electronic component) held by the tool head is then lowered into position onto the board.

A disadvantage of these existing automatic positioning systems is that their overhead positioning systems (i.e.: their movable tool head assembly) tends to be large and bulky. This is due to the fact that the tool head assembly is typically driven by small motors powering drive screws which position the tool head. Being large and bulky, such overhead positioning systems have high inertia, and tend to vibrate excessively, making alignment difficult.

These disadvantages are due at least in part to the fact that, in these systems, both the "coarse" and the "fine" positioning of the electronic component with respect to the printed circuit board is accomplished by successive "coarse" and "fine" positioning of the tool head above a stationary circuit board. A problem with this approach is that any vibration in the mechanism which positions the tool head either requires time for the vibration to dissipate prior to alignment, or results in poor alignment. Moreover, should the operator even touch the positioning head, this alone may cause sufficient vibration to result in alignment problems or delays.

In the second type of existing system, the positioning tool head remains at a fixed location, and the printed circuit board is moved thereunder. A disadvantage of this system is that uniform heating of the circuit board is hard to achieve. This is due to the fact that the system's pre-heater is positioned at a fixed location under the platform which supports the movable printed circuit board. Accordingly, as the circuit board platform is moved around during component positioning, different components are exposed to different degrees of pre-heating, resulting in non-uniform temperatures across the circuit board.

A further disadvantage with this second type of system is that it also is large and bulky. This is due to the fact that the component platform supporting the printed circuit board needs to travel a large distance under the tool head when positioning various components. Thus, a large printed circuit board slide is required to position components on the circuit board.

Patent application US 5,903,662 A discloses an automated component placement apparatus where a tool head position can be controlled relative to a frame supporting the tool head with four degrees of freedom, allowing a linear displacement along the X, Y, and Z directions, as well as a rotation around an axis parallel to the Z axis. Movable alignment optics enable an optical control of the positioning of the tool head relative to a component platform. In a special embodiment, relative positioning errors between the component to be placed on the component platform and the target placement site may be corrected by displacing the component platform in the x and Y directions, or by a combination of the movement of the tool head and the movement of the component platform.

Patent application US 5,044,072 A discloses an automatic component placement apparatus being equipped with a tool head mounted on a frame that is positioned over a carriage member adapted to hold a component platform. The tool head can be moved along and rotated around a vertical Z axis. The carriage member is adjustable in the horizontal X and Y directions. A retractable beam splitter allows for simultaneous observation of the tool head bottom and a target surface on the component platform, when being placed between the two.

### Summary of the Invention:

All examples given below which do not fall under the scope of the invention as set out in the appended claims are not to be considered as embodiments and examples of the invention.

The present invention provides systems for positioning a tool head with respect to a component platform as disclosed in claim 1.

An optical system which simultaneously views the tool head and the component platform permits the precise alignment of the tool head above a desired location on the component platform. Accordingly, the tool head can be lowered such that an electronic component (which is held by the tool head) is positioned at an exact desired location on a printed circuit board (which is held by a component platform).

In accordance with the present invention, the "component platform" described herein may refer to a typical electronic "board holder" or "slide". It is to be understood, however, that the present invention is not so limited. Rather, references to an electronic component platform are understood to include to include any form of component positioning platform.

In various preferred aspects of the present invention, the tool head may be a heated gas soldering / desoldering tool, but may also include any other form of component positioning head. In various aspects of the invention, the component platform preferably comprises a printed circuit board holder. It is to be understood, however, that the present invention is not so limited. Other potential automatic alignment uses are contemplated. For example, the tool may comprise a solder paste applicator, an adhesive / solder paste dispensing system, printing head, or any other system for placement of a solid, liquid or gel on a surface.

In the invention, both the tool head and the component platform are manually positionable in X and Y directions. As will be explained, an important advantage of the present invention is that very accurate positioning (i.e.: alignment) of the tool head with the component platform (e.g. "board holder") in X and Y directions can be achieved without using small stepper motor positioning systems. Rather, simple manual manipulation of each of the tool head and the component platform can result in rapid alignment.

In preferred aspects, the tool head is slidably positionable in X and Y directions. In a most preferred aspect, a first pair of positioning rods are provided on opposite sides of the frame. A pair of positioning arms are provided. These positioning arms are each slidably positionable in a Y direction along one of the first pair of positioning rods. A second pair of positioning rods are also provided. These second pair of positioning rods span between the positioning arms such that the tool head is slidably positionable in an X direction along the second pair of positioning rods. Accordingly, by moving the tool head from side-to-side along the second pair of positioning rods between the positioning arms, and by moving the positioning arms back and forth along the first pair of positioning rods, manual adjustment of the position of the tool head in the X and Y directions is achieved. It is to be understood that this most preferred tool head positioning system is exemplary and that any suitable system for positioning the tool head in both the X and Y directions is contemplated to be within the scope of the present invention.

The component platform is movable by manually rotating fine positioning screws, and is manually positionable in X and Y directions. In preferred aspects, movement of the tool head in the Z direction is accomplished by stepper motors.

Preferably, manually slidable linear bearings (i.e. a rod and bearings assembly), are used both to move the tool head along its positioning rods and to move the positioning arms along its positioning rods. However, any suitable positioning system may be used, keeping within the scope of the present invention. For example, the present invention may optionally include positioning the tool head and the positioning arms with positioning screws driven by small motors.

Similarly, although the mechanism used to adjust the position of the component platform preferably comprises manual movement of the component platform by hand-turning fine positioning screws, the present invention may optionally include positioning the component platform with positioning screws driven by small motors.

An important advantage of having the tool head and the component platform separately positionable is that "coarse" alignment can be achieved by first moving the tool head, followed by "fine" positional alignment by then moving the component platform.

In the most preferred system of operation, "coarse" alignment is provided by moving the tool head (while the component platform remains stationary). Thereafter, "fine" alignment is provided by moving the component platform (while the tool head remains stationary). This system of providing "fine" positional alignment by moving the component platform is particularly advantageous in minimizing vibrational effects, as follows. First, the camera is attached to the tool head. Thus, any vibration in the tool head will cause vibration in the image. Therefore, by stopping movement of the tool head after "coarse" alignment has been completed, and by thus avoiding making "fine" positional adjustment mechanisms on the tool head, the tool head is less likely to vibrate. In preferred aspects, only the Z directional movement of the tool head is accomplished by small stepper motors, such that the operator need not manually position (and thereby vibrate) the tool head as the component is finally positioned on the component platform.

Secondly, the larger movable component platform is less likely to vibrate than the smaller tool head. This results in reduced vibration by making it easier to perform "fme" positional adjustment by moving the component platform. In preferred aspects, the component platform is manually positionable. A particular advantage of having the component platform be manually positionable is its mechanical simplicity, which reduces the size and complexity of the device.

It is to be understood that although the present invention includes an exemplary automatic positioning system for the tool head and a manual positioning system for the component platform, the present invention also comprises systems in which both the tool head and the component platform are automatically positionable.

Advantageously, gross (i.e. "coarse") positional movement of the tool head may be accomplished manually. Specifically, manual adjustment of the position of the tool head can be accomplished by sliding the tool head along linear "rod" bearings in each of the X and Y directions, as follows. In preferred aspects, an operator can push a first button to unlock movement of the tool head in the X (side to side) direction, and then manually drag the tool head in the X direction. Similarly, the operator can push a second button to unlock movement of the positioning arms such that the tool head moves in the Y (back and forth) direction, and then manually drag the tool head in the X direction. Accordingly, the tool head is then moved to a desired position in an X direction and then in a perpendicular Y direction. Separate optional manual movement of the tool head in each of the X and Y directions is advantageous in that it permits rapid "coarse" alignment.

Thereafter, separate perpendicular positioning screws may be used to "finely" adjust the positions of the component platform in each of the X and Y directions.

In accordance with a preferred aspect of the present invention, the "coarse" (i.e. "gross") positional alignment between the electronic component and the component platform is accomplished by first moving the tool head (while the component platform remains stationary). Thereafter, the "fine" positional alignment between the electronic component and he component platform is accomplished by moving the component platform (while the tool head remains stationary).

Preferably, such sequential movement of the tool head and the component platform is performed while simultaneously viewing the positions of both the tool head and the component platform with an optical system. The optical system specifically shows the alignment of the tool head and the component platform by showing the exact position of the tool head over the component platform.

In preferred aspects, the optical system comprises a movable camera and beam splitter assembly which can be slidably extended such that the beam splitter is positioned directly between the tool head and the component platform. The camera is positioned to simultaneously view the tool head and the component platform through the moveable beam splitter.

The present invention further provides a method of aligning the position of a tool head with respect to a component platform, wherein the tool head and the component platform are both connected to a frame, and wherein the tool head and the component platform are both individually adjustably positionable in X and Y directions with respect to the frame, as disclosed in claim 14.

In preferred aspects, simultaneous viewing of the positions of the tool head and the component platform with an optical system comprises: positioning a movable beam splitter between the tool head and the component platform; and viewing through the beam splitter with a camera.

An important advantage of the present invention is that it permits very accurate positioning of the integrated circuit chip at a desired location on a printed circuit board.

The positioning of the integrated circuit chip can be accomplished very rapidly, as the present optical system permits simultaneous viewing of the exact movement of the integrated circuit chip with respect to the exact movement of the printed circuit board.

By permitting simultaneous movement of both the positioning head used to hold the electronic component and the component platform therebelow, the present invention reduces the overall footprint of the device required for electronic component assembly.

Also, by permitting simultaneous movement of both the positioning head used to hold the electronic component and the component platform therebelow, the present invention makes it easier to perform an accurate component placement.

Moreover, by permitting simultaneous viewing of the movement of the electronic component and the movement of the component platform, the present system facilitates a rapid and accurate alignment between these components.

### Brief Description of the Drawings

Fig. 1A is a perspective view of the present invention, with the optical system retracted, prior to component placement.
Fig. 1B is a perspective view of the present invention, with the optical system extended, prior to component placement.
Fig. 1C is a perspective view of the present invention, with the optical system retracted, at the time of component placement.
Fig. 2A is a side elevation view of the present invention, corresponding to Fig. 1A.
Fig. 2B is a side elevation view of the present invention, corresponding to Fig. 1B.
Fig. 2C is a side elevation view of the present invention, corresponding to Fig. 1C.

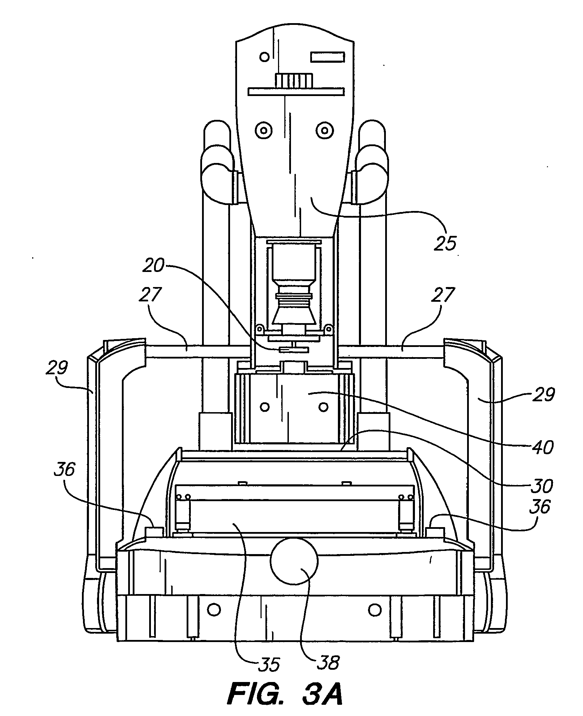

Fig. 3A is a front elevation view of the present invention corresponding to Figs. 1A and 1B.

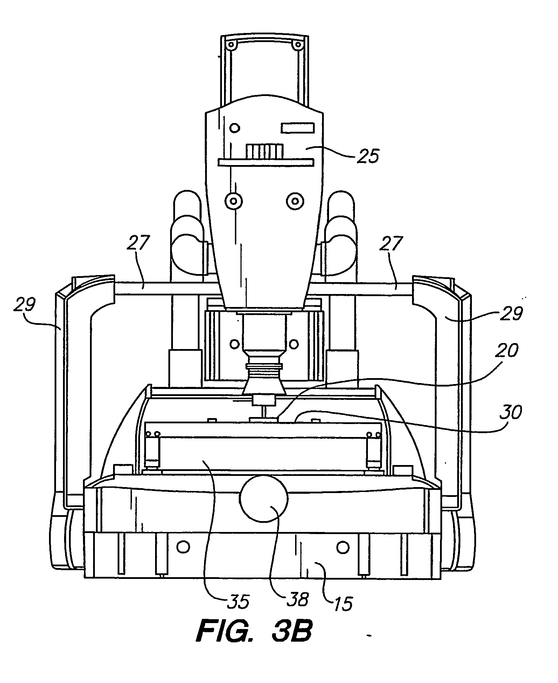

Fig. 3B is a front elevation view of the present invention corresponding to Fig. 1C.

### Detailed Description of the Preferred Embodiments

Referring to the attached Figs., the present system provides an alignment system 10 for positioning an electronic component 20 at a preferred (i.e.: target) location 31 on a printed circuit board 30 or other pad or substrate. Component 20 is held in position by a vacuum tube 26 extending downwardly from movable tool head 25. Similarly, printed circuit board 30 is held in position by a movable component platform 35.

Alignment system 10 comprises a frame 15 to which both tool head 25 and component platform 35 are attached. In accordance with the present invention, both tool head 25 and component platform 35 are separately positionable in X and Y directions.

In optional preferred aspects, vacuum tube 26 is rotatable about its longitudinal axis, thereby permitting component-to-board alignment in a further dimension (i.e.: component 20 can be rotated into a preferred position above component platform 30, prior to placement).

Electronic component 20 preferably comprises an integrated circuit chip having an array of ball solder leads 21 on its underside or edges. It is to be understood, however, that electronic component 20 is not limited only to integrated circuit chip, but may instead comprise any sort of electrical or non-electrical component. Additionally, tool head 25 may preferably comprise a heated gas soldering / desoldering tool head, but also is not so limited. Rather, tool head 25 may comprise any sort of component positioning head or substance (e.g.: gel /glue) application head.

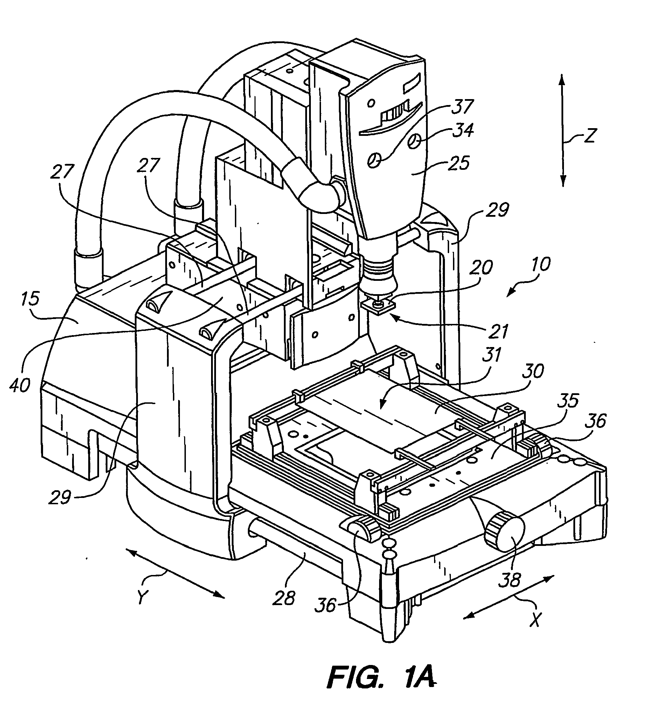

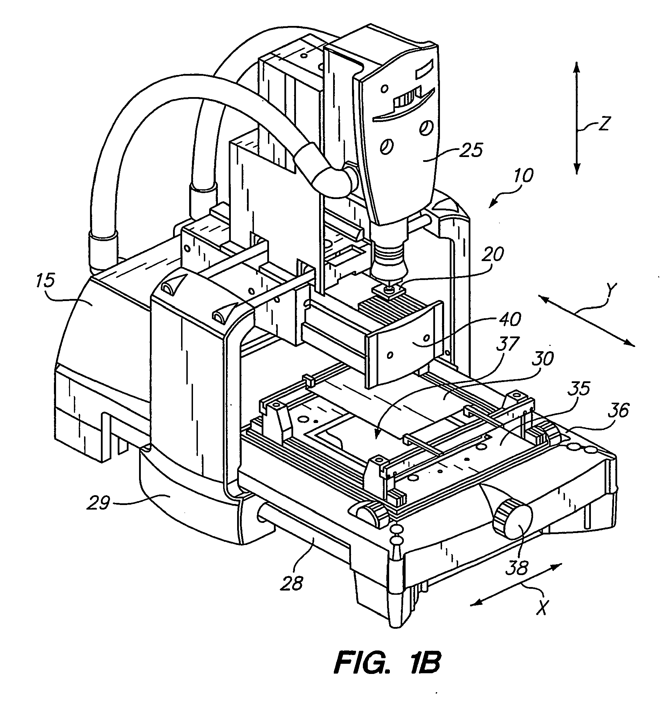

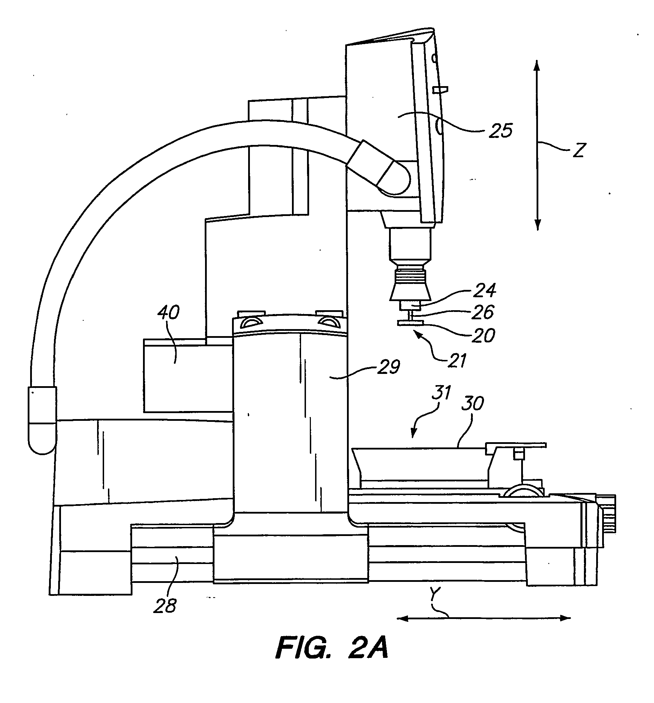

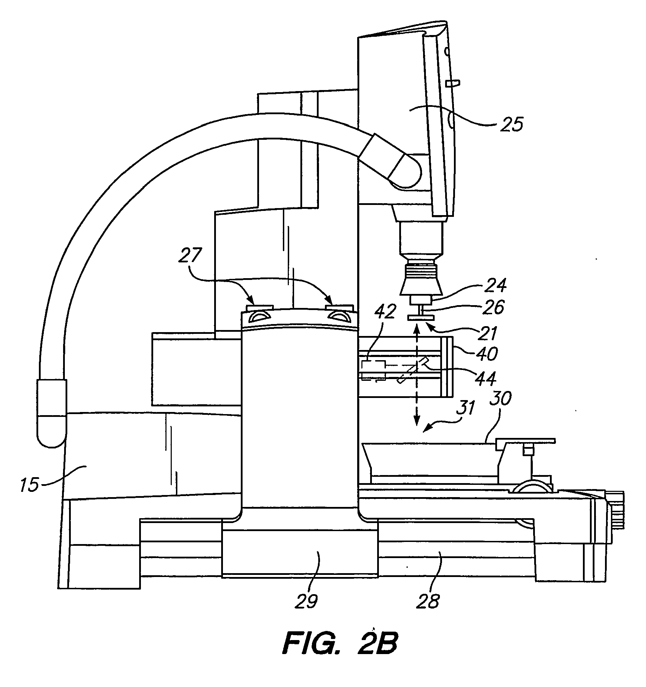

In accordance with the present invention, electronic component 20 is positioned at target location 31 on printed circuit board 30 using retractable optical system 40, as follows. Retractable optical system 40 is slidably movable between a "pushed in" or "retracted" position (as shown in Figs. 1A and 2A) and a "pulled out" or "extended" position (as shown in Figs. 1B and 2B). As shown in Fig. 2B, retractable optical system 40 preferably comprises an internal camera 42 and a beam splitter 44 (shown in dotted lines).

Initially, prior to component placement, as shown in Figs. 1B and 2B, assembly 40 is "pulled out". At this time, camera 42 views an image through beam splitter 42 such that it simultaneously views leads 21 on component 20 and target area 31 on printed circuit board 30. With optical assembly 40 "pulled out", tool head 25 is then moved (in X and Y directions) such that component 20 is positioned roughly above target area 31. Such movement comprises a "coarse" positioning.

Manual movement of tool head 25 in the X and Y directions is achieved as follows. Tool head 25 is slidably positionable along rods 27. Thus, tool head 25 may be slidably positioned side-to-side along rods 27 in the X direction.

Similarly, positioning arms 29 are slidably movable along rods 28 such that arms 29 be slidably positioned back and forth in the Y direction. Such X and Y movement of tool head 25 comprises "coarse" alignment of tool head 25 and target region 31. Preferably, as shown in Fig. 1A , the operator may push button 34 to unlock movement of tool head 25 (along rods 27), or may push button 37 to unlock movement of positioning arms 29 (along rods 28). Thus, tool head 25 is preferably separately positionable in either of the X and Y directions (while movement in the other direction is prevented) by the operator depressing buttons 34 and 37 separately. This optional feature of the invention further assists in accurate component alignment as the tool head can be manually positioned first in the X direction, and then in the Y direction (or vice versa).

After positioning tool head 25, component platform 35 is then moved (in X and Y directions) such that printed circuit board 30 is then positioned in precise alignment with component 20. Such movement comprises "fine" positioning alignment. In preferred aspects, manually adjustable knobs 36 and 38 can be used to rotate fine positioning screws which move component platform 35. For example, knob 36 can be used to move component platform 35 in the X direction and knob 38 can be used to move component platform 35 in the Y direction. The positioning screws which are rotated by knobs 36 and 38 preferably comprise "micrometer" adjustment screws. For example, in preferred aspects, a suitable pitch for such positioning screws ranges from 20 to 100 rotations per inch. In an exemplary embodiment of the invention constructed by the Applicants, a positioning screw having a pitch of 48 turns per inch was used. Such micrometer scale screws permit precise X and Y directional alignment between component 20 and target region 31 to be accomplished manually. In an exemplary embodiment of the invention constructed by the Applicants, component platform 35 is dimensioned large enough to handle a 8" by 10" printed circuit board 30. To achieve precise positional alignment, it was only necessary for component platform 35 to move printed circuit board 30 by small distances (specifically, on the order of plus or minus 1/4 inch).

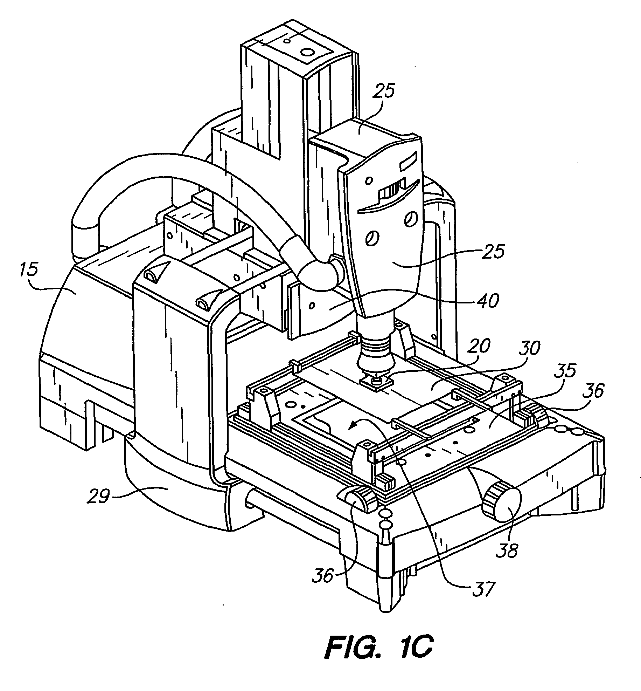

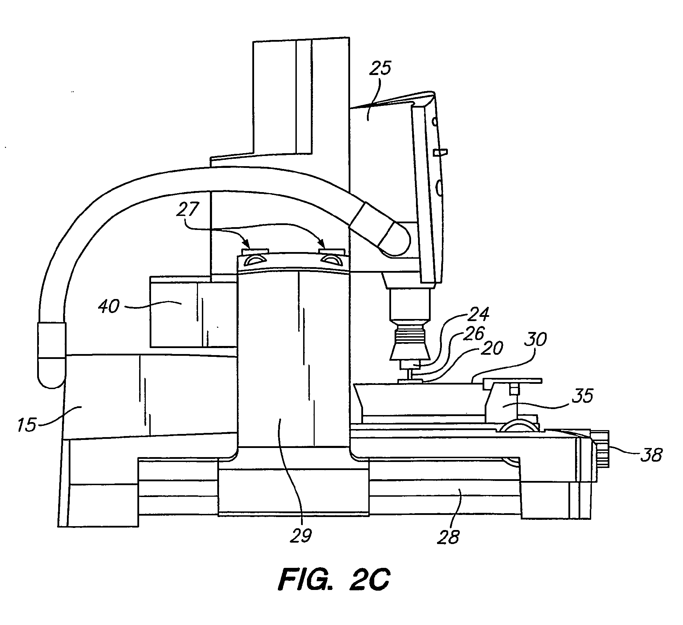

As explained above, and as shown in Fig. 2B, camera 42 takes an image through beam splitter 44 which simultaneously shows the positions of component 20 and printed circuit board 30. After component 20 has been positioned in precise alignment with target region 31 of printed circuit board 30, optical system 40 is then retracted (i.e.: "pushed back in" to the position as was shown in Fig. 1A and 2A). Thereafter, as shown in Figs. 1C and 2C, tool head 25 is then lowered (i.e.: moved downwardly in the Z direction) such that component 20 is positioned directly on printed circuit board 30. In preferred aspects, this downward movement is controlled by stepper motors such that precise Z directional movement is achieved. Precise mechanical lowering of tool head 25 thus ensures that component 20 is positioned at an appropriate height such that its leads 21just touch printed circuit board 30.

At this time, heater 24 (which surrounds vacuum tube 26) emits a heated gas which heats component 20 such that its array of leads 21 solders into the preferred target location 31 on printed circuit board 30. In addition, heated gas is also passed upwardly through pre-heater 37 (positioned under component platform 35), thereby directly heating a lower surface the printed circuit board 30. An advantage of heating printed circuit board 30 by pre-heater 37 heating its underside is that the board can be heated to a temperature just less than the melting point of the solder. Accordingly, only a small amount of heat needs to be applied from above component 20 through heater 24 in tool head 25 to solder electronic component 20 into position. In the absence of heat applied upwardly through pre-heater 37 under component platform 35, it would be necessary to apply much more heat with tool head 25 alone. Unfortunately, this may tend to increase thermal shock to the board, causing localized heating, thereby warping the circuit board.

## Claims

1. A system for manually positioning a tool head with respect to a component platform, comprising:
a frame (15);
a tool head (25) supported by the frame, the tool head being manually coarsely adjustably positionable in X and Y directions with respect to the frame; wherein the tool head further having a first button (34) to release a locking state of the tool head so that the tool head can move in X direction and a second button (37) to release a locking state of the tool head so that the tool head can move in Y direction;
a component platform (35) connected to the frame, the component platform being manually finely adjustably positionable in X and Y directions with respect to the frame; and wherein the component platform further having a first positioning screw with a first knob (36) for moving the component platform in X direction and a second positioning screw with a second knob (38) for moving the component platform in Y direction ; and
an optical system (40) positionable to simultaneously view the tool head and the component platform.

2. The system of Claim 1, wherein the tool head comprises a soldering / desoldering tool head (25).

3. The system of Claim 1, wherein the tool head comprises a component positioning head.

4. The system of Claim 1, wherein the tool head comprises a printing head.

5. The system of Claim 1, wherein the component platform comprises a printed circuit board holder.

6. The system of Claim 1, wherein the screw pitch ranges from 20 to 100 turns per inch.

7. The system of Claim 1, further comprising:
at least one positioning rod (27) for moving the tool head in the X direction; and
at least one positioning rod (28) for moving the tool head in the Y direction.

8. The system of Claim 1, further comprising:
a first positioning rod (28) connected to the frame;
a positioning arm (29) which is slidably positionable along the first positioning rod; and
a second positioning rod (27) connected to the positioning arm, wherein the tool head is slidably positionable along the second positioning rod.

9. The system of Claim 8, wherein the positioning arm (29) which is slidably positionable in the Y direction along the first positioning rod, and the tool head (25) is slidably positionable in the X direction along the second positioning rod (27).

10. The system of Claim 1, further comprising:
a first pair of positioning rods (28) connected to opposite sides of the frame;
a pair of positioning arms (29) which are each slidably positionable along one of the first pair of positioning rods; and
a second pair of positioning rods (27) spanning between the positioning arms (29), wherein the tool head is slidably positionable along the second pair of positioning rods.

11. The system of Claim 1, wherein the optical system comprises:
a camera; and
a beam splitter (44), the beam splitter being movable to a position such that the camera (42) simultaneously views the tool head and the component platform through the beam splitter.

12. The optical system of Claim 11, wherein the beam splitter (44) is retractable such that it can be moved away from a location between the tool head and the component platform, thereby permitting the tool head to be moved to a position adjacent the component platform.

13. The system of Claim 1, further comprising:
a printed circuit board positioned on the component platform.

14. A method for manually positioning a tool head with respect to a component platform, comprising:
a frame (15);
a tool head (25) supported by the frame, the tool head being manually coarsely adjustably positionable in X and Y directions with respect to the frame; wherein the tool head further having a first button (34) to release a locking state of the tool head so that the tool head can move in X direction and a second button (37) to release a locking state of the tool head so that the tool head can move in Y direction;
a component platform (35) connected to the frame, the component platform being manually finely adjustably positionable in X and Y directions with respect to the frame; and wherein the component platform further having a first positioning screw with a first knob (36) for moving the component platform in X direction and a second positioning screw with a second knob (38) for moving the component platform in Y direction; and
positioning the tool head while the component platform is maintained at a fixed location; and then
positioning the component platform while the tool head is maintained at a fixed location,
while simultaneously viewing the positions of the tool head and the component platform with an optical system (40) positioned between the tool head and the component platform.

15. The method of Claim 14, wherein simultaneously viewing of the positions of the tool head and the component platform with an optical system positioned between the tool head and the component platform comprises:
positioning a movable beam splitter (44) between the tool head and the component platform; and
viewing through the beam splitter with a camera (42).

## Patentansprüche

1. System zum manuellen Positionieren eines Werkzeugkopfes bezüglich einer Komponentenplattform, umfassend:
einen Rahmen (15);
einen Werkzeugkopf (25), der von dem Rahmen gehaltert wird, wobei der Werkzeugkopf manuell grob einstellbar in X- und Y-Richtung bezüglich des Rahmens positionierbar ist; wobei der Werkzeugkopf ferner eine erste Taste (34) zum Lösen eines Verriegelungszustands des Werkzeugkopfes, so dass der Werkzeugkopf sich in X-Richtung bewegen kann, und eine zweite Taste (37) zum Lösen eines Verriegelungszustands des Werkzeugkopfes, so dass der Werkzeugkopf sich in Y-Richtung bewegen kann, aufweist;
eine Komponentenplattform (35), die mit dem Rahmen verbunden ist, wobei die Komponentenplattform manuell fein einstellbar in X- und Y-Richtung bezüglich des Rahmens positionierbar ist; und wobei die Komponentenplattform ferner eine erste Positionierschraube mit einem ersten Drehknopf (36) zum Bewegen der Komponentenplattform in X-Richtung und eine zweite Positionierschraube mit einem zweiten Drehknopf (38) zum Bewegen der Komponentenplattform in Y-Richtung aufweist; und
ein optisches System (40), das zum gleichzeitigen Betrachten des Werkzeugkopfes und der Komponentenplattform positionierbar ist.

2. System gemäß Anspruch 1, wobei der Werkzeugkopf einen Löt-/Entlöt-Werkzeugkopf (25) umfasst.

3. System gemäß Anspruch 1, wobei der Werkzeugkopf einen Komponentenpositionier-Werkzeugkopf umfasst.

4. System gemäß Anspruch 1, wobei der Werkzeugkopf einen Druckkopf umfasst.

5. System gemäß Anspruch 1, wobei die Komponentenplattform einen Leiterplattenhalter umfasst.

6. System gemäß Anspruch 1, wobei die Ganghöhe der Schraube 20 bis 100 Umdrehungen pro Zoll entspricht.

7. System gemäß Anspruch 1, ferner umfassend:
mindestens eine Positionierstange (27) zum Bewegen des Werkzeugkopfes in der X-Richtung; und
mindestens eine Positionierstange (28) zum Bewegen des Werkzeugkopfes in der Y-Richtung.

8. System gemäß Anspruch 1, ferner umfassend:
eine erste Positionierstange (28), die mit dem Rahmen verbunden ist;
einen Positionierarm (29), welcher entlang der ersten Positionierstange gleitend positionierbar ist;
eine zweite Positionierstange (27), die mit dem Positionierarm verbunden ist, wobei der Werkzeugkopf entlang der zweiten Positionierstange gleitend positionierbar ist.

9. System gemäß Anspruch 8, wobei der Positionierarm (29) in der Y-Richtung entlang der ersten Positionierstange gleitend positionierbar ist und der Werkzeugkopf (25) in der X-Richtung entlang der zweiten Positionierstange (27) gleitend positionierbar ist.

10. System gemäß Anspruch 1, ferner umfassend:
ein erstes Paar von Positionierstangen (28), die mit gegenüberliegenden Seiten des Rahmens verbunden sind;
ein Paar von Positionierarmen (29), welche jeweils entlang einer Positionierstange des ersten Paares von Positionierstangen gleitend positionierbar sind; und
ein zweites Paar von Positionierstangen (27), die zwischen den Positionierarmen (29) aufgespannt sind,
wobei der Werkzeugkopf entlang des zweiten Paares von Positionierstangen gleitend positionierbar ist.

11. System gemäß Anspruch 1, wobei das optische System umfasst :
eine Kamera; und
einen Strahlenteiler (44), wobei der Strahlenteiler in eine solche Position bewegbar ist, dass die Kamera (42) gleichzeitig den Werkzeugkopf und die Komponentenplattform durch den Strahlenteiler hindurch betrachtet.

12. Optisches System gemäß Anspruch 11, wobei der Strahlenteiler (44) zurückziehbar ist, derart, dass er von einem Ort zwischen dem Werkzeugkopf und der Komponentenplattform wegbewegt werden kann, wodurch ermöglicht wird, dass der Werkzeugkopf in eine der Komponentenplattform benachbarte Position bewegt wird.

13. System gemäß Anspruch 1, ferner umfassend:
eine Leiterplatte, die auf der Komponentenplattform positioniert ist.

14. Verfahren zum manuellen Positionieren eines Werkzeugkopfes bezüglich einer Komponentenplattform, umfassend:
einen Rahmen (15);
einen Werkzeugkopf (25), der von dem Rahmen getragen wird, wobei der Werkzeugkopf manuell grob einstellbar in X- und Y-Richtung bezüglich des Rahmens positionierbar ist; wobei der Werkzeugkopf ferner eine erste Taste (34) zum Lösen eines Verriegelungszustands des Werkzeugkopfes, so dass der Werkzeugkopf sich in X-Richtung bewegen kann, und eine zweite Taste (37) zum Lösen eines Verriegelungszustands des Werkzeugkopfes, so dass der Werkzeugkopf sich in Y-Richtung bewegen kann, aufweist;
eine Komponentenplattform (35), die mit dem Rahmen verbunden ist, wobei die Komponentenplattform manuell fein einstellbar in X- und Y-Richtung bezüglich des Rahmens positionierbar ist; und wobei die Komponentenplattform ferner eine erste Positionierschraube mit einem ersten Drehknopf (36) zum Bewegen der Komponentenplattform in X-Richtung und eine zweite Positionierschraube mit einem zweiten Drehknopf (38) zum Bewegen der Komponentenplattform in Y-Richtung aufweist; und
Positionieren des Werkzeugkopfes, während die Komponentenplattform in einer festen Position gehalten wird; und danach
Positionieren der Komponentenplattform, während der Werkzeugkopf in einer festen Position gehalten wird,
während gleichzeitig die Positionen des Werkzeugkopfes und der Komponentenplattform mit einem optischen System (40) betrachtet werden, das zwischen dem Werkzeugkopf und der Komponentenplattform positioniert ist.

15. Verfahren gemäß Anspruch 14, wobei das gleichzeitige Betrachten der Positionen des Werkzeugkopfes und der Komponentenplattform mit einem optischen System, das zwischen dem Werkzeugkopf und der Komponentenplattform positioniert ist, umfasst:
Positionieren eines beweglichen Strahlenteilers (44) zwischen dem Werkzeugkopf und der Komponentenplattform; und
Betrachten durch den Strahlenteiler hindurch mit einer Kamera (42).

## Revendications

1. Système pour positionner manuellement une tête d'outil par rapport à une plateforme pour composants, comprenant :
une structure (15) ;
une tête d'outil (25) supportée par la structure, la tête d'outil étant positionnable manuellement et grossièrement, à des fins de réglage, dans les directions X et Y par rapport à la structure ; la tête d'outil ayant, en outre, un premier bouton (34) pour libérer un état verrouillé de la tête d'outil de sorte que la tête d'outil peut se déplacer dans la direction X et un second bouton (37) pour libérer un état verrouillé de la tête d'outil de sorte que la tête d'outil peut se déplacer dans la direction Y ;
une plateforme pour composants (35) connectée à la structure, la plateforme pour composants étant positionnable manuellement et finement, à des fins de réglage, dans les directions X et Y par rapport à la structure ; la plateforme pour composants comportant, en outre, une première vis de positionnement ayant une première molette (36) pour déplacer la plateforme pour composants dans la direction X et une seconde vis de positionnement ayant une seconde molette (38) pour déplacer la plateforme pour composants dans la direction Y ; et
un système optique (40) positionnable pour observer simultanément la tête d'outil et la plateforme pour composants.

2. Système selon la revendication 1, dans lequel la tête d'outil forme tête d'outil de soudage/dessoudage (25).

3. Système selon la revendication 1, dans lequel la tête d'outil forme tête de positionnement de composant.

4. Système selon la revendication 1, dans lequel la tête d'outil forme tête d'impression.

5. Système selon la revendication 1, dans lequel la plateforme pour composants forme support de carte de circuit imprimé.

6. Système selon la revendication 1, dans lequel le pas des vis va de 20 à 100 spires par pouce.

7. Système selon la revendication 1, comprenant, en outre :
au moins une tige de positionnement (27) pour déplacer la tête d'outil dans la direction X ; et
au moins une tige de positionnement (28) pour déplacer la tête d'outil dans la direction Y.

8. Système selon la revendication 1, comprenant, en outre :
une première tige de positionnement (28) connectée à la structure ;
un bras de positionnement (29) positionnable par coulissement le long de la première tige de positionnement ; et
une seconde tige de positionnement (27) connectée au bras de positionnement, la tête d'outil étant positionnable par coulissement le long de la seconde tige de positionnement.

9. Système selon la revendication 8, dans lequel le bras de positionnement (29) est positionnable par coulissement, dans la direction Y, le long de la première tige de positionnement, et la tête d'outil (25) est positionnable par coulissement, dans la direction X, le long de la seconde tige de positionnement (27).

10. Système selon la revendication 1, comprenant, en outre :
une première paire de tiges de positionnement (28) connectées à des côtés opposés de la structure ;
une paire de bras de positionnement (29) qui sont chacun positionnables par coulissement le long de l'une des tiges de positionnement de la première paire ; et
une seconde paire de tiges de positionnement (27) s'étendant entre les bras de positionnement (29), la tête d'outil étant positionnable par coulissement le long de la seconde paire de tiges de positionnement.

11. Système selon la revendication 1, dans lequel le système optique comprend :
une caméra ; et
un diviseur de faisceau (44), le diviseur de faisceau étant mobile vers une position telle que la caméra (42) observe simultanément la tête d'outil et la plateforme pour composants au travers du diviseur de faisceau.

12. Système optique selon la revendication 11, dans lequel le diviseur de faisceau (44) est rétractable de sorte qu'il peut être déplacé à l'écart d'un emplacement entre la tête d'outil et la plateforme pour composants, permettant ainsi à la tête d'outil d'être déplacée vers une position voisine de la plateforme pour composants.

13. Système selon la revendication 1, comprenant, en outre :
une carte de circuit imprimé positionnée sur la plateforme pour composants.

14. Procédé pour le positionnement manuel d'une tête d'outil par rapport à une plateforme pour composants, comprenant :
une structure (15) ;
une tête d'outil (25) supportée par la structure, la tête d'outil étant positionnable manuellement et grossièrement, à des fins de réglage, dans les directions X et Y par rapport à la structure ; la tête d'outil ayant un premier bouton (34) pour libérer un état verrouillé de la tête d'outil de sorte que la tête d'outil peut se déplacer dans la direction X et un second bouton (37) pour libérer un état verrouillé de la tête d'outil de sorte que la tête d'outil peut se déplacer dans la direction Y ;
une plateforme pour composants (35) connectée à la structure, la plateforme pour composants étant positionnable manuellement et finement, à des fins de réglage, dans les directions X et Y par rapport à la structure ; la plateforme pour composants comportant, en outre, une première vis de positionnement ayant une première molette (36) pour déplacer la plateforme pour composants dans la direction X et une seconde vis de positionnement ayant une seconde molette (38) pour déplacer la plateforme pour composants dans la direction Y ;
le procédé comprenant :
le positionnement de la tête d'outil tandis que la plateforme pour composants est maintenue en un emplacement fixe ; puis
le positionnement de la plateforme pour composants tandis que la tête d'outil est maintenue en un emplacement fixe,
tout en observant simultanément les positions de la tête d'outil et de la plateforme pour composants au moyen d'un système optique (40) positionné entre la tête d'outil et la plateforme pour composants.

15. Procédé selon la revendication 14, dans lequel l'observation simultanée des positions de la tête d'outil et de la plateforme pour composants, au moyen d'un système optique positionné entre la tête d'outil et la plateforme pour composants, comprend :
le positionnement d'un diviseur de faisceau (44) mobile entre la tête d'outil et la plateforme pour composants ; et
l'observation, via le diviseur de faisceau, au moyen d'une caméra (42).
